(19) Europäisches Patentamt
European Patent Office
Office européen des brevets

(11) **EP 2 803 141 B1**

(12) **EUROPEAN PATENT SPECIFICATION**

(45) Date of publication and mention of the grant of the patent:
**01.11.2017 Bulletin 2017/44**

(51) Int Cl.:
***H03M 7/30*** *(2006.01)*

(21) Application number: **12781488.7**

(86) International application number:
**PCT/RU2012/000211**

(22) Date of filing: **23.03.2012**

(87) International publication number:
**WO 2013/141741 (26.09.2013 Gazette 2013/39)**

(54) **METHOD AND DEVICE FOR COMPRESSING DATA REPRESENTING A TIME DEPENDENT SIGNAL**

VERFAHREN UND EINRICHTUNG ZUM KOMPRIMIEREN VON DATEN ZUR DARSTELLUNG EINES ZEITABHÄNGIGEN SIGNALS

PROCEDE ET DISPOSITIF DE COMPRESSION DE DONNEES REPRESENTANT DU SIGNAL CARACTERISTIQUE DEPENDANT DU TEMP

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.11.2014 Bulletin 2014/47**

(73) Proprietor: **Siemens Aktiengesellschaft 80333 München (DE)**

(72) Inventors:
• **KUSHNIKOV, Oleg Vadimovich St. Petersburg 192174 (RU)**
• **MOKHOV, Ilya Igorevich St. Petersburg 192281 (RU)**
• **VASILIEVA, Aleksandra Sergeevna St. Petersburg 199106 (RU)**

(56) References cited:
• **SHEKHIREV A V ET AL: "Music files compression based on time-frequency representation of audio signal", STRATEGIC TECHNOLOGIES, 2008. IFOST 2008. THIRD INTERNATIONAL FORUM ON, IEEE, PISCATAWAY, NJ, USA, 23 June 2008 (2008-06-23), pages 340-342, XP031309182, ISBN: 978-1-4244-2319-4**

**Description**

The present invention relates to a method and a signal processing device for compressing data representing a time dependent signal.

Data compression plays a pivotal role in managing a colossal amount of data. For instance, many modern day engineering, scientific, and statistical activities mandate the collection of massive amounts of electronic data for processing and maintaining information. For example, the electronic data can be a representation of a time varying signal. The management of the data is an extremely demanding task, wherein the management can also comprise storage and transmission of the data. Efficient data management is achievable by intelligent data compression techniques whereupon the storage space required for storing the information present in the data and/or the transmission bandwidth required for transmitting the data are greatly reduced.

Currently, when colossal amounts of data are collected, for example in case of a continuous stream of data representing a time varying signal collected during a continuous monitoring exercise performed on a machine, i.e. monitoring vibrations of the machine during its operation, the computation and the storage of the Fourier transform, i.e. spectrum data of the time varying signal, especially in its entirety, necessitates a huge amount of storage space.

The normal methods of compressing the spectrum data involve either using universal lossless compression tools (ZIP) or using memory optimised encoding. Such a method is disclosed in 'Music files compression based on time-frequency representation of audio signal' by Shekhirev et al. However, compression ratios (ratio of the storage space/resources required to store the compressed data to the storage space/resources required to store the actual data) for the aforementioned methods are remarkably low and are inefficient methods of data compression. Herewith, the storage space and data transmission bandwidth are not substantially reduced.

The object of the present invention is to provide an efficient method and a signal processing device for compressing data representing a time dependent signal.

The above object is achieved by a method for compressing data according to claim 1 and a signal processing device according to claim 8.

The underlying object of the invention is to compress data $D(nT)$ representing a time dependent signal $A(t)$. The time dependent signal $A(t)$ comprises a plurality of time dependent partial signals $A_i(t)$. The method of compressing commences with a step, wherein a plurality of spectra $S_i(f)$ is received. Each spectrum $S_i(f)$ uniquely corresponds to one of the time dependent partial signals $A_i(t)$ and each spectrum $S_i(f)$ comprises a plurality of frequencies $f_j$ and a plurality of amplitudes $a_{j,i}$ of the plurality of frequencies $f_j$. The amplitudes $a_{j,i}$ are uniquely assigned to $f_j$ and are measures of contributions of $f_j$ in $A_i(t)$.

In a subsequent step, for each spectrum $S_i(f)$ the plurality of amplitudes $a_{j,I}$ are normalised for obtaining a plurality of normalised amplitudes $b_{j,i}$. In a following step, for each frequency $f_j$, the normalised amplitudes $b_{j,i}$ are processed based on a distribution of the normalised amplitudes $b_{j,i}$ with respect to a threshold value $(T_v)$, and one or more respective model parameters $(MP_j)$ are determined for representing the distribution of the normalised amplitudes $b_{j,i}$. In a subsequent step, a compressed data set (CDS) is generated. CDS comprises at least the one or more model parameters and the frequency $f_j$. Therefore, the CDS is possible to compress huge amounts of data.

Herein, for each partial signal $A_i(t)$, a time stamp $t_i$ is generated. The time stamp $t_i$ represents a time instant at which the partial signal $A_i(t)$ was acquired. The time stamps $t_i$ are beneficial for identifying the sequence of occurrence of $A_i(t)$, for spectrum wise indexing of the plurality of amplitudes $a_{j,i}$ and the plurality of normalised amplitudes $b_{j,i}$, and for processing the plurality of normalised amplitudes $b_{j,i}$ for obtaining the CDS.

Herein, for each frequency $f_j$, if every normalised amplitude $b_{j,i}$ is lesser than the threshold value $(T_v)$, then the $MP_j$ determined from the step of processing will comprise an average value (AV) of the normalised amplitudes $b_{j,i}$ for $f_j$. Additionally, CDS further comprises the first time stamp $t_1$. Though the contribution of $f_j$ in $D(nT)$ is less than a desired value (i.e. the threshold value), i.e. $f_j$ is not a significant frequency. However, the contribution of $f_j$ can be modelled and maintained by preserving the mean value of $f_j$ in $D(nT)$ for a obtaining a faithful representation of $D(nT)$ by the CDS.

Herein, CDS comprises for each spectrum $S_i(f)$, a sum $SF_i$ of the plurality of amplitudes $a_{j,i}$. This is advantageous because it helps in the reconstruction of $a_{j,i}$, because the processing is performed on the normalised amplitudes.

Herein, the threshold value is proportional to a reciprocal of a cardinal number (NoP) of the plurality of frequencies $f_j$ and also to a tolerance factor $(T_f)$. This renders the threshold variable, and helps in influencing the distribution of the normalised amplitudes $b_{j,i}$.

Finally, the method further comprises a step subsequent to the step of processing, wherein a reconstructed data $D'(nT)$ is constructed by processing CDS. In a subsequent step, a correlation co-efficient (CC) is determined between the data $D(nT)$ and the reconstructed data $D'(nT)$. The threshold is varied responsive to the CC, and the aforementioned steps are repeated till a satisfactory CC is obtained. By this, the accuracy of CDS is improved.

According to yet another embodiment of the present invention, for each frequency $f_j$, if every normalised amplitude $b_{j,i}$ is greater than the threshold value $(T_v)$, and if a difference $\Delta = b_{j,i}^{max} - b_{j,i}^{min}$ between extreme values ( $b_{j,i}^{max}$ , $b_{j,i}^{min}$ ) of the normalised amplitudes

$b_{j,i}$ is less than the threshold value ($T_v$), then the $MP_j$ determined from the step of processing will comprise an average value (AV) of the normalised amplitudes $b_{j,i}$ for $f_j$. Additionally, CDS further comprises the first time stamp $t_1$. The contribution of $f_j$ in D(nT) is more than a desired value (i.e. the threshold value), thereby making $f_j$ a significant frequency. The contribution of $f_j$ can be modelled and maintained by preserving the mean value of $f_j$ in D(nT) for a obtaining a faithful representation of D(nT) by the CDS.

According to yet another embodiment of the present invention, for each frequency $f_j$, if at least one of the normalised amplitudes $b_{j,i}$ is not less than the threshold value ($T_v$) and if the difference between the extreme values $\Delta = b_{j,i}^{max} - b_{j,i}^{min}$ of the normalised amplitudes $b_{j,i}$ is not less than the threshold value ($T_v$), then in the step of processing an approximation algorithm is performed for modelling the distribution of the normalised amplitudes $b_{j,i}$ of $f_j$. Thus, the $MP_j$ determined from the step of processing will comprise one or more model parameters of the approximation algorithm. By this, the approximation algorithm simplifies the modelling complicated distributions. According to a variation of the aforementioned embodiment, CDS also comprises the respective time stamps $t_k$.

According to a variation of the aforementioned embodiment, the approximation algorithm is a polynomial fit, which is a simple method of modelling a distribution.

According to another variation of the aforementioned embodiment, the approximation algorithm is a step function, which increases the speed of modelling a nonlinear distribution.

According to a preferred variation of the aforementioned embodiment, the approximation algorithm is an iterative end point fit algorithm, for example a Ramer-Douglas-Peucker algorithm. Thus, a fewer set of points are obtained for defining a distribution containing a large set of points. Thus, very high compression ratios and accuracy of compression are achieved.

A signal processing device configured to compress data D(nT) according to any of the aforementioned embodiments is hereby disclosed. The signal processing device comprises a spectral data receiver module, an amplitude normaliser module, a comparator module, a parameter module and a memory unit. The spectral data receiver module receives the plurality of spectra $S_i(f)$. The amplitude normaliser module normalises the plurality of amplitudes $a_{j,i}$ for each of the plurality of frequencies $f_j$ of each of the plurality of spectra $S_i(f)$. Thus, a plurality of normalised amplitudes $b_{j,i}$ is obtained. The comparator module compares each of the plurality of normalised amplitudes $b_{j,i}$ with the threshold value ($T_v$). The parameter module processes the normalised amplitudes $b_{j,i}$ of the frequency $f_j$ based on the distribution of the normalised amplitudes $b_{j,i}$ with respect to the threshold value ($T_v$).

Thus, the one or more respective parameters ($MP_j$) for representing the distribution of the normalised amplitudes $b_{j,i}$ are determined. The memory unit stores the compressed data set (CDS).

According to an embodiment of the present invention, the signal processing device further comprises a correlation module. The correlation module determines the correlation coefficient (CC) between the data D(nT) and the reconstructed data D'(nT). By this, the accuracy of CDS for representing the data D(nT) is improved.

According to an embodiment of the present invention, the signal processing device further comprises a spectrum module. The spectrum module receives each of the time dependent partial signals $A_i(t)$ and computes the respective spectrum $S_i(f)$. The spectrum module can be integrated with the aforementioned modules in cascade. By this, the versatility of the signal processing device is improved, as the spectra $S_i(f)$ is readily computed and is available for compressing the data D(nT).

The aforementioned and other embodiments of the invention related to a method and a signal processing device for compressing data representing a time dependent signal will now be addressed with reference to the accompanying drawings of the present invention. The illustrated drawings and the embodiments are intended to illustrate, but not to limit the invention. The accompanying drawings contain the following figures, in which like numbers refer to like parts, throughout the description and drawings.

The figures illustrate in a schematic manner further examples of the embodiments of the invention, in which:

FIG 1     depicts a condition monitoring system comprising a data acquisition module and a signal processing device compressing data representing a time dependent signal,

FIG 2     depicts various modules of the signal processing device referred to in FIG 1, wherein exploded views of a plurality of spectra, an amplitude array, and a normalised amplitude array schematically illustrate operations of a spectrum module, a spectral data receiver module, an amplitude normaliser module respectively,

FIG 3     depicts an exemplary amplitude array, and an exemplary normalised amplitude array referred to in FIG 2, and

FIG 4     depicts an exemplary manner of constructing a compressed data set for reconstructing data for compressing the data representing the time dependent signal referred to in FIG 1, and

FIG 5     depicts a flowchart of the method for compressing data representing compressing data representing the time dependent signal.

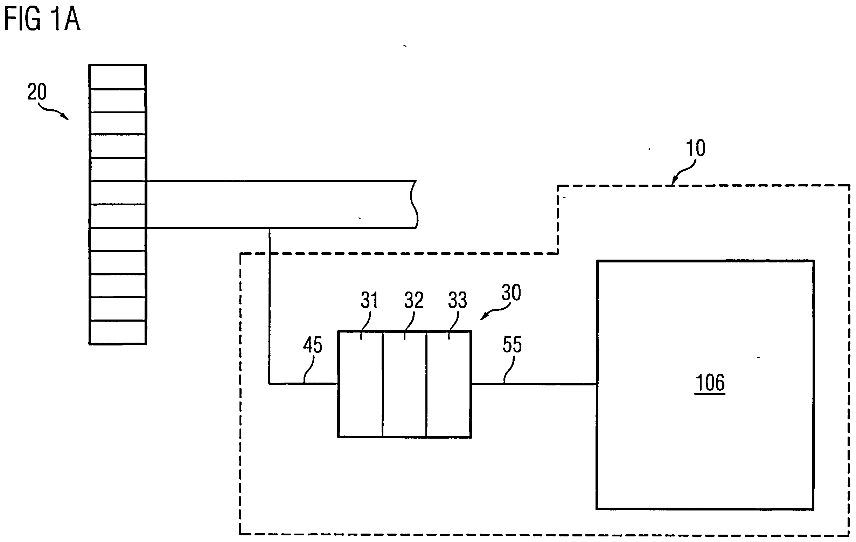

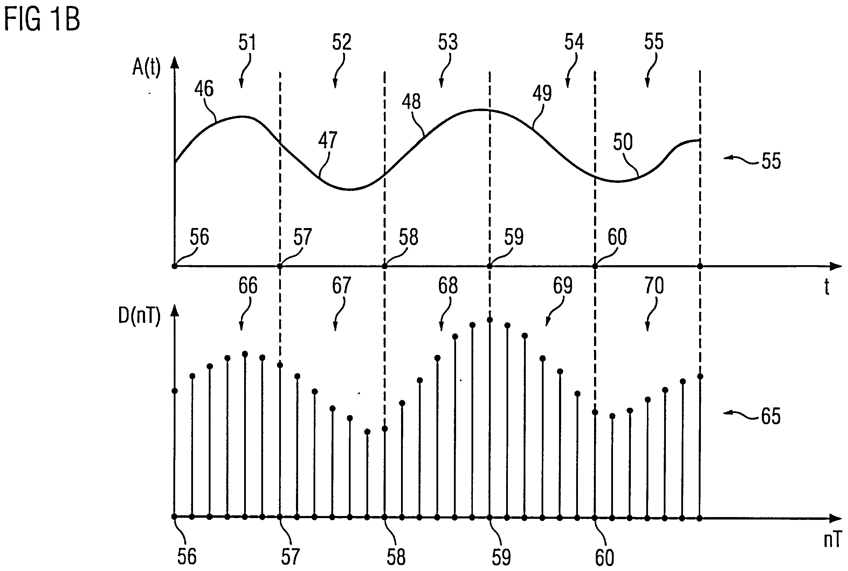

A condition monitoring system 10 coupled to a motor 20 for monitoring health of the motor 20 is depicted in FIG 1.

The condition monitoring system 10 comprises a data acquisition module 30 (hereinafter referred to as "the DAQ 30") and a signal processing device 40 in accordance with an embodiment of the invention. The DAQ 30 acquires a time dependent signal A(t) 45, which is a continuous signal (characterised by an independent time variable "t") that pertains to vibrations of the motor 20. The DAQ 30 provides data D(nT) 65 to the signal processing device 40. D(nT) 65 is a discrete-time (characterised by an independent variable "nT") representation of A(t) 45, which is subsequently processed for compressing D(nT) 65 for achieving the object of the present invention.

The DAQ 30 comprises a sensor 31, a signal conditioner 32, and an analog to digital converter ADC 33 (ADC). The sensor 31 acquires A(t) 45 and provides the same to the signal conditioner 32. The signal conditioner 32 conditions A(t) 45 and provides A'(t) to the ADC 33. The ADC 33 digitises A'(t), thereby creating D(nT) 65, which is provided to the signal processing device 40, which effectively represents A(t).

A(t) 45 may be continuously acquired by the DAQ 30 and may be construed as comprising a plurality of time dependent partial signals $A_i(t)$ (with i=1, 2,...,NoS) 46-50. $A_i(t)$ 46-50 can be construed as A(t) 45 acquired during a plurality of individual time intervals $\Delta t_i$ (with i=1,2,...,NoS) 51-55, respectively, or as time domain windowed A(t) 45, wherein window intervals correspond to $\Delta t_i$ 51-55. Alternatively, the DAQ 30 may acquire A(t) 45 during $\Delta t_i$ 51-55 by means of time domain windowing, therewith A(t) 45 may be construed as a sequential collection of $A_i(t)$ 46-50.

Durations of $\Delta t_i$ 51-55 may be definable by a user or can be fixed or variable depending on the type of A(t) 45, signal processing requirements, features of the DAQ 30 and/or the signal processing device 40, et cetera. The durations can be microseconds, milliseconds, or in seconds. $\Delta t_i$ 51-55 are generally contiguous. However, $\Delta t_i$ 51-55 may be overlapping or separated by certain spans of time, et cetera.

Herein, the term "partial signals" is defined as a portion of A(t) 45 acquired by the DAQ during respective $\Delta t_i$ 51-55.

Herein "NoS" is a dimensionless entity and refers to a cardinal number of $A_i(t)$ 46-50 acquired during $\Delta t_i$ 51-55, which in entirety constitute to form A(t) 45. I.e. NoS represents the number of partial signals $A_i(t)$.

A plurality of time stamps $t_i$ (with i=1,2,...,NoS) 56-60 are determined from A(t), wherein each time stamp $t_i$ 56-60 represents a time of start of the respective partial signal $A_i(t)$ 46-50 acquired during the time interval $\Delta t_i$ 51-55. For instance, time stamp $t_1$ 56 denotes the time of start of the partial signal $A_1(t)$ 46.

The data D(nT) 65 is a discrete-time representation of A(t) 45. Thus, $A_i(t)$ 46-50 results in a plurality of discrete-time partial signals $D_i(nT)$ (with i=1,2,...,NoS; n=1,2,...,NoP) 66-70 respectively, wherein $D_i(nT)$ 66-70 corresponds to D(nT) 65 present in $\Delta t_i$ 51-55. $D_i(nT)$ 66-70 may also be obtained by discrete-time domain windowing of A(t) 45. Therefore, D(nT) 65 comprises discrete-time representations of the plurality of partial signals $A_i(t)$ 51-55, i.e. $D_i(nT)$ 66-70. Furthermore, D(nT) 65 may also be a digital representation of the discrete-time equivalent of A(t).

Herein, "NoP" is a dimensionless entity and refers to a cardinal number of samples contained in each discrete-time partial signal $D_i(nT)$ 66-70. "NoP" is also equal to a cardinal number of frequencies determinable from an NoP-point Discrete Fourier Transform (DFT) performed on $D_i(nT)$ 66-70. The significance of the term "NoP" will be elucidated in the subsequent sections.

"NoP" for $D_i(nT)$ 66-70 may be varied by varying a sampling rate of the ADC 33, i.e. by under sampling or over sampling. The "NoP" may also be modified by zero-padding, or in another alternative aspect, the duration of $\Delta t_i$ 51-55 may be varied to effect a change of "NoP". A variation of "NoP" accordingly varies the cardinal number of frequencies determinable from an NoP-point DFT.

Herein, the time stamps $t_i$ 56-60 also represent the time of start for $D_i(nT)$ 66-70 respectively. Therefore, the time stamps $t_i$ 56-60 contain information regarding the time of acquisition of the $D_i(nT)$ 66-70, i.e. the start time of $\Delta t_i$ 51-55, and are beneficial for compression of D(nT) 65 as well as for reconstruction of D(nT) 65. In an alternate aspect, $t_i$ 56-60 can be any instances of time of the respective $\Delta t_i$ 51-55, from which the information regarding the time of acquisition of the $A_i(nT)$ 66-70 is computable. In other words, the time stamps $t_i$ 56-60 represent a time instant at which the respective partial signal $A_i(t)$ and $D_i(nT)$, respectively, have been acquired.

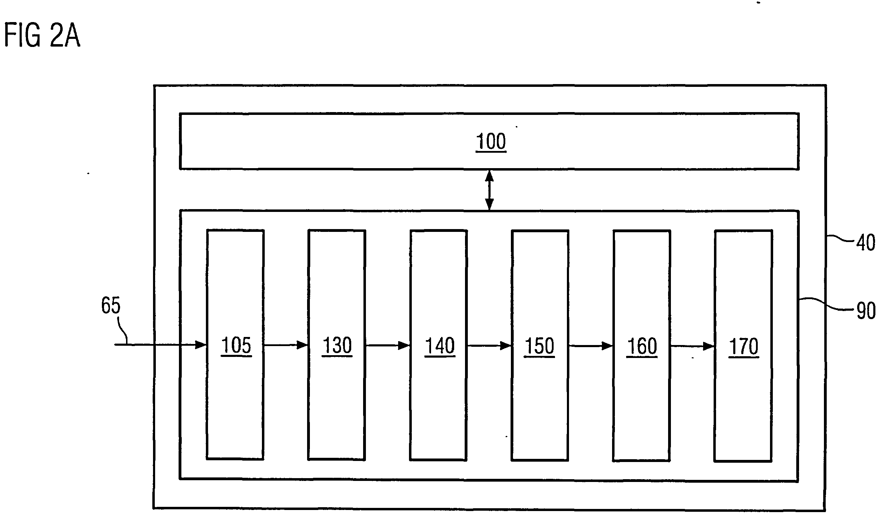

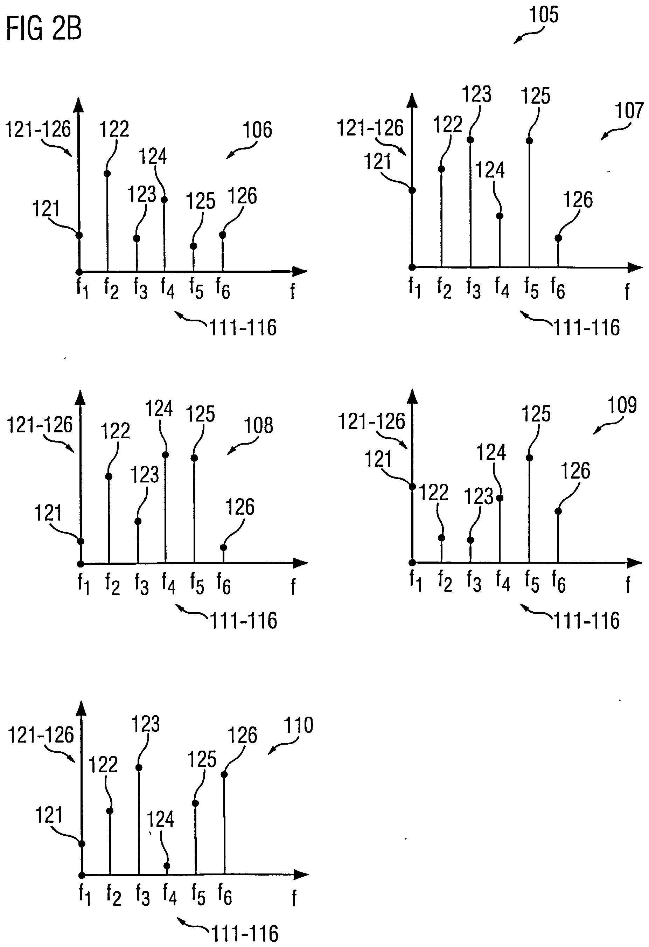

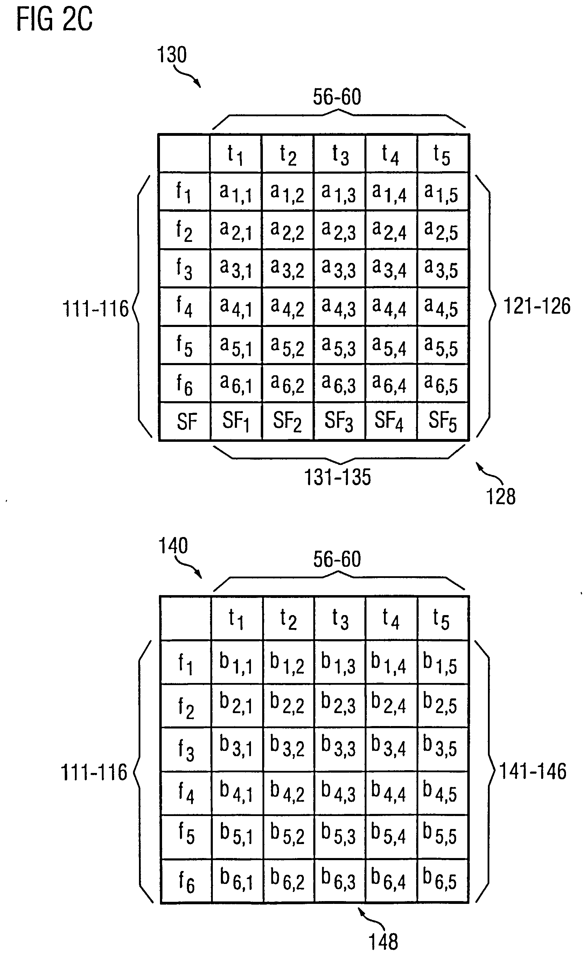

The signal processing device 40 comprising a processor 90 and a memory unit 100 for compressing D(nT) 65 is depicted in FIG 2. Exemplary NoP = 6 and NoS = 5 is depicted in FIG 2.

The processor 90 comprises a spectrum module 105, a spectral data receiver module 130, an amplitude normaliser module 140, a comparator module 150, a parameter module 160, and a correlation module 170. The aforementioned modules 105, 130, 140, 150, 160, 170 are configured to compress data D(nT).

The spectrum module 105 receives $D_i(nT)$ 66-70 and computes a plurality of spectra $S_i(f)$ (with i=1,2,...,NoS) 106-110.

The module 105 computes $S_i(f)$ 106-110 may be a plurality of NoP-point (Discrete Fourier Transforms) DFTs. $S_i(f)$ 106-110 comprises a plurality of frequencies $f_j$ (with j=1,2,...,NoP) 111-116 and a plurality of amplitudes $a_{j,i}$ (with j=1,2,...,NoP; with i=1,2,...,NoS) 121-126 of the frequencies $f_j$ 111-116. Herein, the computed amplitudes $a_{j,i}$ 121-126 are uniquely assigned to $f_j$ 111-116 and are measures of contributions of $f_j$ 111-116 in $A_i(t)$ 46-50. This assignment of amplitudes $a_{j,i}$ 121-126 and frequencies $f_j$ 111-116 is in compliance with the well-known definition of a spectrum of a time dependent signal, i.e. the amplitudes are a measure of the contribution of the assigned frequency to the underlying time dependent signal.

A schematic operation of the module 105 is depicted as an exploded view "105". Herein, for each of $S_i(f)$ 106-110, the horizontal axis "f" represents "frequency" ($f_j$ 111-116), and the vertical axis "A" represents "amplitude", that is the amplitudes ($a_{j,i}$ 121-126) of $f_j$ 111-116 of the underlying time dependent signal.

An exemplary manner for realizing the operation of the module 105 is elucidated herein. For example, $D_i(nT)$ 66-70 are received by the signal processing device 40 and the same are buffered as blocks of data of a particular length in the memory unit 100. Each block of data corresponds to each of $D_i(nT)$ 66-70 acquired during each of $\Delta t_i$ 51-55. Each block of data is time stamped with a respective $t_i$ 56-60 for identifying the start time of the $D_i(nT)$ 66-70. The blocks corresponding to $D_i(nT)$ 66-70 are then retrieved and processed for computing $S_i(f)$ 106-110.

Herein, $a_{j,i}$ 121-126 and $f_j$ 111-116 of $S_i(f)$ 106-110 may be displayed as a two dimensional amplitude array 128 arranged in rows and columns, for example with NoP rows (representing the NoP $f_j$ 111-116) and NoS columns (representing the NoS $D_i(nT)$ 66-70).

Each of the $S_i(f)$ 106-110 is computed from a respective $D_i(nT)$ 66-70. Therefore, "NoS" also stands for "Number of Spectra".

The spectral data receiver module 130 receives the spectra $S_i(f)$ 106-110 from the spectrum module 105. The module 130 then arranges a vector of $a_{j,i}$ 121-126 and a vector of $f_j$ 111-116 present in $S_i(f)$ 106-110. Thus, a vector $a_{j,i}$ 121-126 is assigned to a respective time stamp $t_i$ 56-60.

In the amplitude array 128, each column "i" of the NoS columns is designated with a respective time stamp $t_i$ 56-60, which corresponds to the respective $D_i(nT)$ 66-70. Similarly, each row "j" of the NoP rows is designated with a respective frequency $f_j$ 111-116. For example, the first column is designated with time stamp $t_1$ 56 and contains all the amplitudes $a_{j,i}$ 121-126 of the frequencies $f_j$ 111-116 computed from $S_1(f)$ 106. Similarly, the first row is designated with $f_1$ 111 and contains the amplitudes $a_{j,i}$ 121-126 of $f_1$ 111 computed from NoS number of spectra $S_i(f)$ 106-110.

An exploded view "130" illustrates an example of the amplitude array 128 for five spectra $S_i(f)$ 106-110 (NoS=5) and six frequencies $f_j$ 111-116 (NoP=6). For example, the column values $a_{1,1}$ 121 to $a_{6,1}$ 126 represent the values of the six frequencies $f_1$ 111 to $f_6$ 116 determined from $S_1(f)$ 106 computed for $D_1(nT)$ 66 bearing the time stamp $t_1$ 56. The row values $a_{3,1}$ 123 to $a_{3,5}$ 123 represent the values of the third frequency "$f_3$ 113" determined from $S_1(f)$ 106 to $S_5(f)$ 110 computed respectively for $D_1(nT)$ 66 to $D_5(nT)$ 70 bearing the respective time stamps $t_1$ 56 to $t_5$ 60.

Furthermore, for each of $S_i(f)$ 106-110 the module 130 computes an algebraic sum $SF_i$ (with i=1 to NoS) 135 of the amplitudes $a_{j,i}$ 121-126 of the frequencies $f_j$ 111-116 .

For example,

$$SF_1 = \sum_{j=1}^{NoP} \alpha_{j,1} \quad , \quad SF_3 = \sum_{j=1}^{NoP} \alpha_{j,3} \quad ,$$

et cetera

Thus, $SF_i$ 135 is also a vector of length "NoS". Furthermore, each of $SF_i$ 135 can uniquely correspond to each of the NoS time stamps $t_i$ 56-60. For example, $SF_1$ corresponds to $t_1$, $SF_3$ corresponds to $t_3$, et cetera.

The amplitude normaliser module 140 receives the amplitude array 128 from the spectral data receiver module 130. For each of $S_i(f)$ 106-110, the amplitudes $a_{j,i}$ 121-126 are normalised by the module 140. Thus, a plurality of normalised amplitudes $b_{j,i}$ (with j=1,2,...,NoP; with i=1,2,...,NoS) 141-146 is obtained. Each of $b_{j,i}$ 141-146 is computed in accordance with the following formula:

$$b_{j,i} = \frac{a_{j,i}}{\sum_{j=1}^{NoP}(a_{j,i})} \quad ,$$

I.e.

$$b_{j,i} = \frac{a_{j,i}}{SF_i}$$

For example,

$$b_{1,3} = \frac{a_{1,3}}{SF_3} \quad , \quad b_{3,2} = \frac{a_{3,2}}{SF_2},$$

et cetera.

Herein, $b_{j,i}$ 141-146 is also arranged into a normalised amplitude array 148 with respect to $S_i(f)$ 106-110 bearing the time stamps $t_i$ 56-60, respectively. The normalised amplitude array 148 again comprises NoP rows and NoS columns. A schematic operation of the module 140 is depicted as an exploded view "140".

In the aforementioned context, the term "normalisation" is defined as, for each $S_i(f)$ 106-110, a process of dividing the individual amplitudes $a_{j,i}$ 121-126 of $f_j$ 111-116 by the algebraic sum of amplitudes $a_{j,i}$ 121-126. Therefore, by normalisation, relational contributions or percentage contributions of each of $f_j$ 111-116 present in each of $A_i(t)$ 46-50 can be measured. Thus, the contribution of a certain frequency $f_j$ 111-116 is assessable and measurable for determining how that particular frequency $f_j$ 111-116 may be represented for the compression of $D(nT)$ 65, which will be explained subsequently.

The NoP rows and NoS columns of the amplitude array 128 and the normalised amplitude array 148 merely illustrate and represent the manner in which the received $a_{j,i}$ 121-126 of $f_j$ 111-116 of each of $S_i(f)$ 106-110 and the corresponding $b_{j,i}$ 141-146 may be arranged for processing the information in a facile manner. These NoP rows and NoS columns may be transposed and the information therein can be represented and processed accordingly without loss of generality.

The aforementioned example (NoP=6 and NoS=5) is merely illustrative, and is not to be construed to be limiting the invention. The NoP and the NoS can be any two positive integers and the magnitudes of NoP and NoS may be immense. For example, for a 256-point FFT computed for 300 spectra, "NoP" is 256, and "NoS" is 300.

Herein, the cardinal number of $f_j$ 111-116, i.e. NoP, determinable from $S_i(f)$ 106-110 is equal to the cardinal number of samples, i.e. again NoP, present in each of $D_i(nT)$ 66-70. For example, the cardinal number is "16" for a 16-point DFT, "32" for a 32-point DFT, and so on. However, for computing $S_i(f)$ 106-110 from $D_i(nT)$ 66-70 in an efficient manner, i.e. for customizing the number of frequencies $f_j$ 111-116 determinable from each of $S_i(f)$ 106-110, $D_i(nT)$ 66-70 may be up-sampled, down-sampled, zero-padded, et cetera, as aforementioned without loss of generality of $D_i(nT)$ 66-70.

Herein, each $S_i(f)$ 106-110 comprises the same vector of frequencies $f_j$ 111-116, i.e. different $S_i(f)$ 106-110 may only differ in the vector of amplitudes $a_{j,i}$ 121-126 computed for different $D_i(nT)$ 66-70. Herein, each frequency $f_j$ 111-116 comprises the same vector of time stamps $t_i$ 56-60.

The comparator module 150 receives the normalised amplitude array 148. For each spectrum $S_i(f)$ 106-110, the module 150 compares the normalised amplitudes $b_{j,i}$ 141-146 with a threshold value $T_v$.

$T_v$ is proportional to a reciprocal of "NoP", i.e. the cardinal number of frequencies (NoP) of $f_j$ 111-116. Herein, a relation between $T_v$ and NoP may be indicated as the following:

$$ T_v \ \propto \ \frac{1}{NoP} $$

By comparing each normalized amplitude $b_{j,i}$ 141-146 of each spectrum $S_i(f)$ 106-110 with the threshold value $T_v$, the comparator module 150 generates a distribution of normalized amplitudes $b_{j,i}$ 141-146 of frequency $f_j$ with respect to $T_v$.

Thereafter, by processing the normalised amplitude array 148 containing $b_{j,i}$ 141-146, and the distribution of $b_{j,i}$ 141-146 with respect to $T_v$ in the parameter module 160, it is possible to model the distribution of $b_{j,i}$ 141-146 over $S_i(f)$ 106-110.

The parameter module 160 receives the normalised amplitude array 148 containing $b_{j,i}$ 141-146, and the distribution of $b_{j,i}$ 141-146 for each frequency $f_j$ 111-116 with respect to $T_v$.

For each frequency $f_j$ 111-116, the normalised amplitude $b_{j,i}$ 141-146 and the distribution of $b_{j,i}$ 141-146 with respect to $T_v$, respectively, are processed to obtain one or more model parameters ($MP_j$) (with j=1 to NoP). The model parameters $MP_j$ are suitable for modelling the distribution of the normalised amplitudes $b_{j,i}$ 141-146. For instance, $b_{1,1}$ to $b_{1,6}$ 141 are processed for obtaining $MP_1$ for modelling $f_1$ 111 and $b_{4,1}$ to $b_{4,6}$ 144 are processed for obtaining $MP_4$ for modelling $f_4$ 114, et cetera.

For each of $f_j$ 111-116, the $MP_j$ depends on a trend of distribution of the $b_{j,i}$ 141-146 of $f_j$ 111-116 with respect to $T_v$. $MP_j$ is computed by modelling the frequencies $f_j$ 111-116 based on the different trends of the distribution of the respective $b_{j,i}$ 141-146.

For this, three different cases are distinguished:

Case 1) In case the trend of the distribution of the respective $b_{j,i}$ 141-146 of a particular frequency $f_j$ 111-116 is such that each of $b_{j,i}$ 141-146 is less than $T_v$, $MP_j$ for representing the normalised amplitudes $b_{j,i}$ of that particular frequency $f_j$ 111-116 is an average value (AV) of the normalized amplitudes $b_{j,i}$ 141-146 of the particular frequency $f_j$ 111-116 of the spectra $S_i(f)$. The average value (AV) for that particular frequency $f_j$ 111-116 is computed by processing the normalised amplitudes $b_{j,i}$ of that particular frequency $f_j$ 111-116 over $S_i(f)$ 106-110 as indicated below:

$$ AV = \frac{\sum_{i=1}^{NoS} b_{j,i}}{NoS} $$

For example, if for $f_1$ 111, if all of $b_{1,1}$ to $b_{1,5}$ 141 are less than $T_v$, then AV for $f_1$ 111 is computed as indicated below:

$$ AV = \frac{\sum_{i=1}^{NoS} b_{1,i}}{NoS} $$

Case 2) In case the trend of the distribution of the normalised amplitudes $b_{j,i}$ 141-146 of frequency $f_j$ 111-116 is such that a difference $\Delta = b_{j,i}^{max} - b_{j,i}^{min}$ between extreme values (i.e. the difference $\Delta$ between the maximum value $b_{j,i}^{max}$ and the minimum value $b_{j,i}^{min}$ of $b_{j,i}$) of the normalised amplitudes $b_{j,i}$ of that particular frequency $f_j$ 111-116 is less than $T_v$, then $MP_j$ for representing the normalised amplitudes $b_{j,i}$ 141-146 of that particular frequency $f_j$ 111-116 is once again the average value (AV) of the normalised amplitudes $b_{j,i}$ 141-146 of the particular

frequency $f_j$ 111-116 as computed above.

For example, if for $f_5$ 115, if $b_{5,4}$ is the maximum value $b_{j,i}^{max}$ and $b_{5,5}$ is the minimum value $b_{j,i}^{min}$, and if the difference $\Delta$ between $b_{5,4}$ and $b_{5,5}$ is less than $T_v$, then AV for $f_5$ 115 is computed as indicated below:

$$AV = \frac{\sum_{i=1}^{NoS} b_{5,i}}{NoS}$$

Case 3) In the remaining cases, if the trend of the distribution of $b_{j,i}$ 141-146 of the particular frequency $f_j$ 111-116 is different from the trends of the aforementioned distributions in cases 1) and 2), the distribution of the normalised amplitudes $b_{j,i}$ 141-146 is modelled and represented by an approximation algorithm. Herein, the $MP_j$ of that particular frequency $f_j$ 111-116 are the resulting model parameters of the approximation algorithm. The approximation algorithm may be one of the following:

- a linear fit, wherein the resulting $MP_j$ defining a linear equation for modelling $b_{j,i}$ 141-146 comprises a slope value, and an axis intercept value;
- a quadratic fit, wherein the resulting $MP_j$ defining a quadratic equation for modelling $b_{j,i}$ 141-146 are one or more coefficients representing a variable of the quadratic equation;
- a cubic fit, wherein the resulting $MP_j$ defining a cubic equation for modelling $b_{j,i}$ 141-146 are one or more coefficients representing a variable of the cubic equation;
- an $n^{th}$ order polynomial fit, wherein the resulting $MP_j$ defining an $n^{th}$ order polynomial equation for modelling $b_{j,i}$ 141-146 are one or more coefficients representing a variable of the $n^{th}$ order polynomial equation;
- a step function, wherein the resulting $MP_j$ defining the step function for modelling $b_{j,i}$ 141-146 is a cumulative function defined as a sum of elementary step functions; or
- an iterative end point fit algorithm, wherein the resulting $MP_j$ defining the iterative end point fit algorithm for modelling $b_{j,i}$ 141-146 may be obtained from a Ramer-Douglas-Peucker algorithm, et cetera.

Thus, depending on the respective distributions of normalized amplitudes $b_{j,i}$ 141-146 for the different frequencies $f_j$ 111-116, model parameters $MP_j$ are computed, finally resulting in data which are suitable to be used as a basis for generating a compressed data set CDS for representing the original data D(nT) 65.

The CDS representing the data D(nT) 65 comprises the following:

- the vector of frequencies $f_j$ 111-116,
- the vector of time stamps $t_i$ 56-60,
- the algebraic sum $SF_i$ 135 of the amplitudes $a_{j,i}$ 121-126 of every spectrum $S_i(f)$, which is beneficial for scaling the $MP_j$ for each of $f_j$ 111-116, because $MP_j$ was created using only $b_{j,i}$ 141-146, and
- the model parameters $MP_j$ for representing the trends of distribution of the normalised amplitudes $b_{j,i}$ 141-148 of every frequency $f_j$ 111-116.

Moreover, for those frequencies $f_j$ 111-116 for which the respective model parameter $MP_j$ is chosen to be the average value (AV) of the normalised amplitudes $b_{j,i}$ 141-146 (i.e. cases 1) and 2) as described above), additionally the first time stamp $t_1$ 56 is assigned to AV.

In general, for all other cases (i.e. cases than cases 1) and 2)) and for all frequencies, respectively, CDS has to contain information whether $MP_j$ is an average value (cases 1) and 2)) or has been modeled by an approximation algorithm (case 3)). If $MP_j$ for a particular frequency $f_j$ 111-116 is based on an approximation algorithm, then the CDS further comprises the following:

- information about the type of approximation algorithm (for example, the step function, the iterative end point fit algorithm, et cetera) used for approximating the normalised amplitudes $b_{j,i}$ 141-148 of the particular frequency $f_j$ 111-116, and
- the $MP_j$ of the approximation algorithm for that particular frequency $f_j$ 111-116 will also contain pairs of one or more amplitude values and respective one or more timestamps $t_i$ 56-60 of that particular frequency $f_j$ 111-116. Herein, the amplitude values can be one or more normalised amplitudes $b_{j,i}$ 141-146 itself or average of a certain number of normalised amplitudes $b_{j,i}$ 141-146 of that particular frequency $f_j$ 111-116.

By processing the CDS, it is possible to substantially reconstruct the data D(nT).

In order to assess the quality of compression before finally storing CDS, a data signal D'(nT) is reconstructed from the compressed data set CDS and compared with the original signal D(nT). For the assessment, the correlation module 170 receives the compressed data set CDS and processes the same for constructing data signal D'(nT) for the corresponding $\Delta t_i$ 51-55.

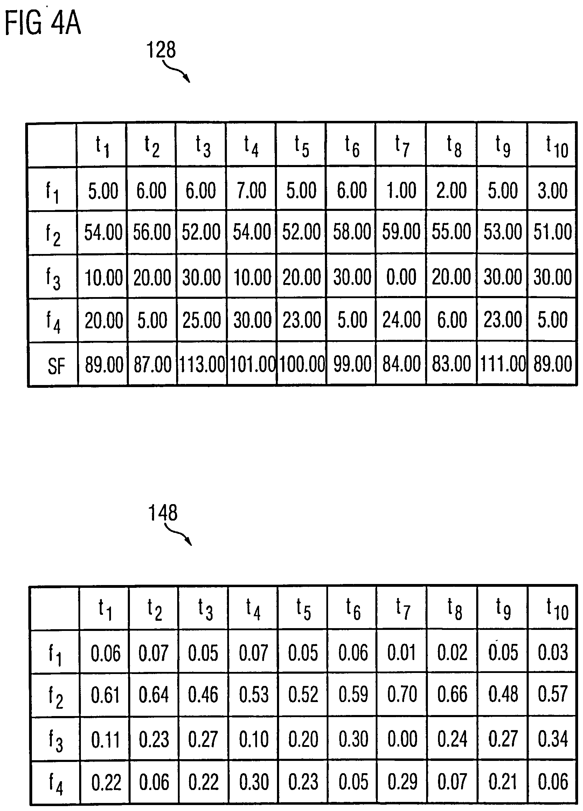

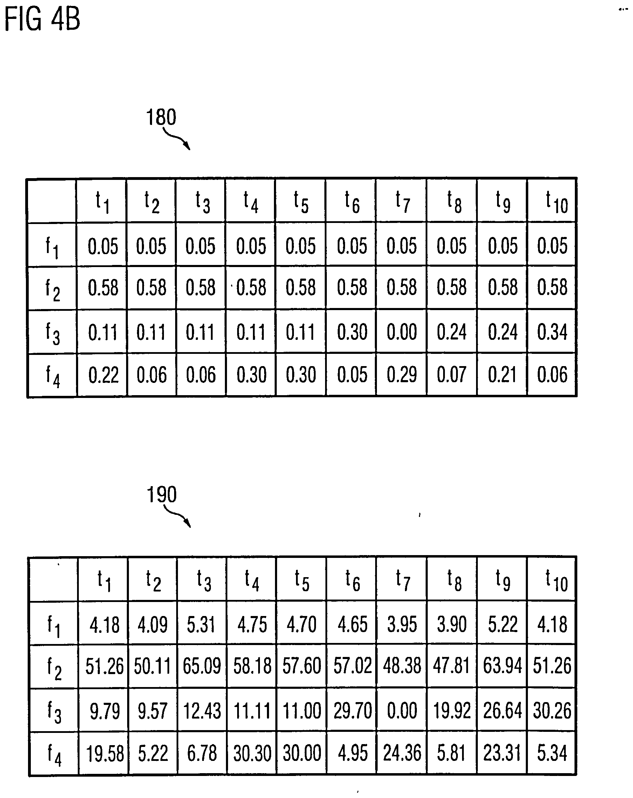

The reconstruction of D'(nT) by processing CDS is explained in an exemplary manner with reference to FIG 4.

The correlation module 170 determines a correlation co-efficient CC by correlating D'(nT) and D(nT). CC is a dimensionless entity and is merely a qualitative index for representing a similarity between D'(nT) and D(nT).

Based on the determined CC, it may be decided to repeat the compression with other preconditions. For example, if the correlation co-efficient indicates that the similarity of D'(nT) and D(nT) is not sufficient, the threshold value $T_v$ would have to be varied. This can result in a varied trend of the distribution of the normalized amplitudes $b_{j,i}$ 141-146 of the frequency $f_j$ 111-116 and, thus, in new model parameters $MP_j'$ for that frequency.

The threshold value $T_v$ may be varied to obtain a varied threshold value $T_v'$ by multiplying $T_v$ with a tolerance factor $T_f$. Herein, a relation between $T_v'$, NoP and $T_f$ may be indicated as the following:

$$T'_v = \frac{T_f}{\text{NoP}}$$

$T_f$ may be varied in order to vary $T_v$. In fact, this results in a change of the distribution of $b_{j,i}$ 141-146 with respect to $T_v$. Thereby, this results in changing the $MP_j$ for every $f_j$ 111-116. For example, if the CC between D'(nT) and D(nT) is between "0" and "0.8", it may be assumed that the quality of the reconstructed signal D'(nT) is poor, and the quality can be improved by lowering the $T_v$, i.e. by reducing $T_f$, thereby selecting different $MP_j$.

Similarly, if CC is "0.8" or more, it can be assumed that the $MP_j$ for reconstructing D'(nT) are sufficient. Then the current CDS is considered as the final CDS and it is stored in memory.

$T_v$, $T_v'$ and $T_f$ are dimensionless entities. $T_f$ merely serves to increase or decrease $T_v$. If $T_f$ is chosen between "0" and "1", then $T_v$ is decreased. Alternatively, if $T_f$ is greater than "1", then $T_v$ is increased. However, preferably $T_f$ should be unequal to "1".

After the variation of the threshold value, the newly defined threshold value $T_v'$ is sent to the comparator module 150. There, the threshold value $T_v$ which is used for comparison with the normalised amplitudes $b_{j,i}$ 141-146 is set to be the new threshold value $T_v'$, i.e. $T_v = T_v'$.

Thereafter, the same steps as described above for determining the distribution of normalized amplitudes $b_{j,i}$ 141-146 of each spectrum $S_i(f)$ 106-110 with respect to the threshold value $T_v$ are conducted. I.e. the comparator module 150 again generates a distribution of $b_{j,i}$ 141-146 with respect to $T_v$, wherein $T_v$ corresponds to the varied threshold value $T_v'$.

After the determination of the distribution, it is again possible to model the distribution of $b_{j,i}$ 141-146 over $S_i(f)$ 106-110.

The parameter module 160 receives information regarding the comparison between each of $b_{j,i}$ 141-146 with $T_v$, i.e. information about the aforementioned distribution.

Again, for each frequency $f_j$ 111-116, the normalised amplitude $b_{j,i}$ 141-146 and the distribution of $b_{j,i}$ 141-146 with respect to $T_v$, respectively, are processed to obtain one or more model parameters $MP_j$, as described above. $MP_j$ is again computed by modelling the frequencies $f_j$ 111-116 based on the different trends of the distribution of the respective $b_{j,i}$ 141-146, again considering the aforementioned three different cases 1), 2) and 3).

After calculation of model parameters $MP_j$ for each frequency $f_j$ 111-116, a new compressed data set CDS is generated, which comprises:

- the vector of frequencies $f_j$ 111-116,
- the vector of time stamps $t_i$ 56-60,
- the algebraic sum $SF_i$ 135 of the amplitudes $a_{j,i}$ 121-126 of every spectrum $S_i(f)$, which is beneficial for scaling the $MP_j$ for each of $f_j$ 111-116, because $MP_j$ was created using only $b_{j,i}$ 141-146, and
- the model parameters $MP_j$ for representing the trends of distribution of the normalised amplitudes $b_{j,i}$ 141-148 of every frequency $f_j$ 111-116.

Moreover, for those frequencies $f_j$ 111-116 for which the respective model parameter $MP_j$ is chosen to be the average value (AV) of the normalised amplitudes $b_{j,i}$ 141-146 (i.e. cases 1) and 2) as described above), additionally the first time stamp $t_1$ 56 is assigned to AV.

In general, for all other cases (i.e. cases than cases 1) and 2)) and for all frequencies, respectively, CDS has to contain information whether $MP_j$ is an average value (cases 1) and 2)) or has been modeled by an approximation algorithm (case 3)). If $MP_j$ for a particular frequency $f_j$ 111-116 is based on an approximation algorithm, then the CDS further comprises the following:

- information about the type of approximation algorithm (for example, the step function, the iterative end point fit algorithm, et cetera) used for approximating the normalised amplitudes $b_{j,i}$ 141-148 of the particular frequency $f_j$ 111-116, and
- the $MP_j$ of the approximation algorithm for that particular frequency $f_j$ 111-116 will also contain pairs of one or more amplitude values and respective one or more timestamps $t_i$ 56-60 of that particular frequency $f_j$ 111-116. Herein, the amplitude values can be one or more normalised amplitudes $b_{j,i}$ 141-146 itself or average of a certain number of normalised amplitudes $b_{j,i}$ 141-146 of that particular frequency $f_j$ 111-116.

The frequencies for which the model parameters have been computed using the approximation algorithms are $f_k$ and the corresponding time stamps stored in the model parameters of $f_k$ are $t_k$.

To assure a sufficient compression quality, as described above, a data signal D'(nT) is again reconstructed from the compressed data set CDS and compared with the original signal D(nT). The correlation module 170 determines the new correlation co-efficient CC by correlating D'(nT) and D(nT).

Based on the determined CC, it may be decided to repeat the compression again with other preconditions. In this case, the aforementioned procedure starting with the variation of the threshold value $T_v$ with another tolerance factor $T_f$ would be repeated, resulting in a new distribution and new model parameters $MP_j$ etc.

Finally, when the CC indicates a sufficient similarity between D'(nT) and D(nT), the respective compressed data set CDS is stored. Since instead of all amplitudes $a_{j,i}$ only average values and/or model parameters $MP_j$ are stored, an effective compression rate can be achieved.

The spectrum module 105 and the spectral data receiver module 130 may be consolidated to form a single module capable of executing the functions of both the modules 105, 130.

The comparator module 150, the parameter module 160 and the correlation module 180 may be consolidated to form a single module capable of executing the functions of the modules 150, 160, 170.

The memory unit 100 is capable of storing the $D_i(nT)$ 66-70 received from the DAQ 30, interim data obtained during different stages of processing $D_i(nT)$ 66-70, by the aforementioned modules 105, 130, 140, 150, 160, 170, $a_{j,i}$ 121-126 and $f_j$ 111-116 computed from $S_i(f)$ 106-110, et cetera.

The one or more of the aforementioned modules 105, 130, 140, 150, 160, 170 are operably coupled to the processor 90 and are realizable as independent modules or as partly consolidated modules or a wholly consolidated module, wherein the processor 90 is configured accordingly for performing respective functions of the one or more aforementioned modules 105, 130, 140, 150, 160, 170. Additionally, the one or more modules 105, 130, 140, 150, 160, 170, may be interconnected and may be locatable inside or outside the processor 90.

The processor 90 may be a general purpose processor, a microcontroller, a Digital Signal Processor, a Field Programmable Gate Array (FPGA), a Partial Dynamic Reconfigurable FPGA, an Application Specific Integrated Circuit, and a combination thereof.

The sufficient modules for achieving the object of the invention are the module 130, the module 140, the module 150 and the module 160. However, signal processing device of FIG 2 is provided with supplementary modules, i.e. the memory unit 100, the module 105, and the module 170.

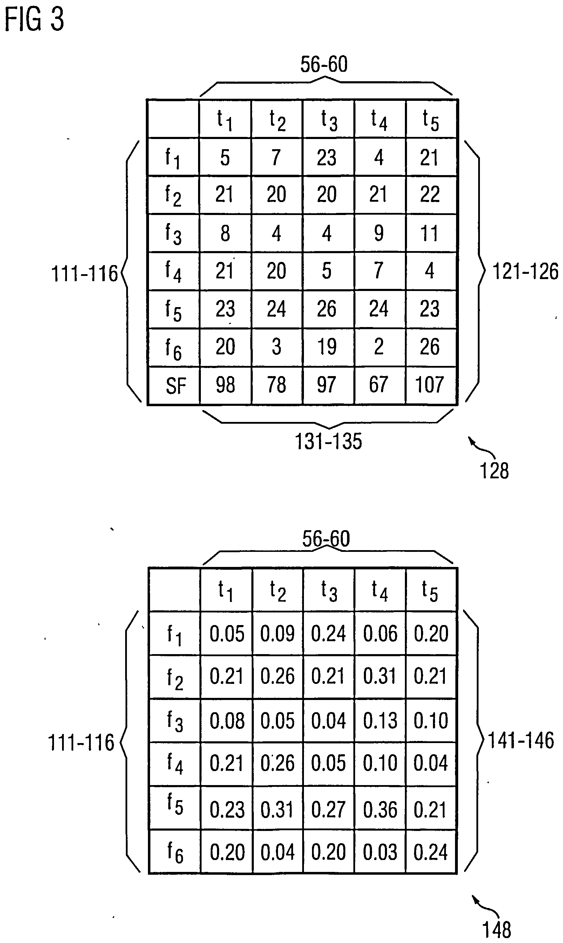

An example of the amplitude array 128 and the normalised amplitude array 148, wherein NoP=4 and NoS=10, comprising exemplary values of $a_{j,i}$ 121-126 and $b_{j,i}$ 141-146 respectively are illustrated in FIG 3. Since NoP is equal to "4", the corresponding $T_v$ is "0.25". The columns of the amplitude array 128 and the normalised amplitude array 148 bear the respective time stamps $t_i$ 56-60.

Herein, for $f_1$, the amplitude array 128 comprises exemplary amplitude values of [5, 6, 6, 7, 5, 6, 1, 2, 5, 3], for $f_2$, the amplitude array 128 comprises exemplary amplitude values of [54, 56, 52, 54, 52, 58, 59, 55, 53, 51], for $f_3$, the amplitude array 128 comprises exemplary amplitude values of [10, 20, 30, 10, 20, 30, 0, 20, 30, 30],

and for $f_4$, the amplitude array 128 comprises exemplary amplitude values of [20, 5, 25, 30, 23, 5, 24, 6, 23, 5] obtained from exemplary ten spectra $S_1(f)$ to $S_{10}(f)$. Correspondingly, $SF_1$ is 89, $SF_2$ is 87, $SF_3$ is 113, $SF_4$ is 101, $SF_5$ is 100, $SF_6$ is 99, $SF_7$ is 84, $SF_8$ is 83, $SF_9$ is 111, and $SF_{10}$ is 89. The each column of the amplitude array 128 is assigned to a respective time stamp $t_1$ to $t_{10}$, generated from the respective $D_1(nT)$ to $D_{10}(nT)$.

Herein, for $f_1$, the normalised amplitude array 148 comprises exemplary normalised amplitude values of [0.06, 0.07, 0.05, 0.07, 0.05, 0.06, 0.01, 0.02, 0.05, 0.03], for $f_2$, the normalised amplitude array 148 comprises exemplary normalised amplitude values of [0.61, 0.64, 0.46, 0.53, 0.52, 0.59, 0.70, 0.66, 0.48, 0.57], for $f_3$, the normalised amplitude array 148 comprises exemplary normalised amplitude values of [0.11, 0.23, 0.27, 0.10, 0.20, 0.30, 0.00, 0.24, 0.27, 0.34], and for $f_4$, the normalised amplitude array 148 comprises exemplary normalised amplitude values of [0.22, 0.06, 0.22, 0.30, 0.23, 0.05, 0.29, 0.07, 0.21, 0.06].

For $f_1$, it may be observed from here that each of the normalised amplitude values of [0.06, 0.07, 0.05, 0.07, 0.05, 0.06, 0.01, 0.02, 0.05, 0.03] is below $T_v$. Therefore, $MP_1$ corresponding to $f_1$ is the average value (AV) of [0.06, 0.07, 0.05, 0.07, 0.05, 0.06, 0.01, 0.02, 0.05, 0.03], which is "0.047" and the first time stamp $t_1$.

For $f_2$, it may be observed from here that each of the normalised amplitude values of [0.61, 0.64, 0.46, 0.53, 0.52, 0.59, 0.70, 0.66, 0.48, 0.57] is above $T_v$, as well as the difference between the extreme values ("0.70" and "0.46") is "0.24", which is below $T_v$. Therefore, $MP_2$ corresponding to $f_2$ is the average value (AV) of [0.61, 0.64, 0.46, 0.53, 0.52, 0.59, 0.70, 0.66, 0.48, 0.57], which is "0.576" and first time stamp $t_1$.

For $f_3$, it may be observed from here that some of the normalised amplitude values of [0.11, 0.23, 0.27, 0.10, 0.20, 0.30, 0.00, 0.24, 0.27, 0.34] are above $T_v$, whereas others are below $T_v$. Also, the difference between the extreme values ("0.30" and "0.00") is "0.30", which is above $T_v$. Therefore, $MP_3$ corresponding to $f_3$ are obtained from Ramer-Douglas-Peucker algorithm, wherein the $MP_3$ constitutes [(0.11, $t_1$), (0.3, $t_6$), (0, $t_7$), (0.24, $t_8$), (0.34, $t_{10}$)].

For $f_4$, it may be observed from here that some of the normalised amplitude values of [0.22, 0.06, 0.22, 0.30, 0.23, 0.05, 0.29, 0.07, 0.21, 0.06] are above $T_v$, whereas others are below $T_v$. Also, the difference between the extreme values ("0.30" and "0.05") is "0.25", which is equal to $T_v$. Therefore, $MP_3$ corresponding to $f_4$ are obtained from Ramer-Douglas-Peucker algorithm, wherein the $MP_3$ constitutes [(0.22, $t_1$), (0.06, $t_2$), (0.3, $t_4$), (0.05, $t_6$), (0.29, $t_7$), (0.07, $t_8$), (0.21, $t_9$), (0.06, $t_{10}$)].

Therefore the CDS comprises the following:

- the vector of frequencies $f_1$ to $f_{10}$,
- the vector of time stamps $t_1$ to $t_{10}$,
- the algebraic sum $SF_1$ to $SF_{10}$ of the amplitudes of every spectrum $S_1(f)$ to $S_{10}(f)$, i.e., [89, 87, 113, 101, 100,99, 84, 83, 111, 89], and

- the model parameters (MP) as indicated below:

  ○ $MP_1$: [(0.047, $t_1$)]
  ○ $MP_2$: [(0.576, t1)]
  ○ $MP_3$: [(0.11, $t_1$), (0.3, $t_6$), (0, $t_7$), (0.24, $t_8$), (0.34, $t_{10}$)], and
  ○ $MP_4$: [(0.22, $t_1$), (0.06, $t_2$), (0.3, $t_4$), (0.05, $t_6$), (0.29, $t_7$), (0.07, $t_8$), (0.21, $t_9$), (0.06, $t_{10}$)].

Herein, $f_3$ and $f_4$ constitute $f_k$, and the time stamps $t_1$, $t_6$, $t_7$, $t_8$ and $t_{10}$ constitute the $t_k$ for $MP_3$ and the time stamps $t_1$, $t_2$, $t_4$, $t_7$, $t_8$, $t_9$ and $t_{10}$ constitute the $t_k$ for $MP_4$.

FIG 4 depicts an exemplary reconstructed amplitude array for reconstructing D'(nT) based on the aforementioned CDS. For each frequency $f_j$ the reconstructed amplitude of $f_j$ depends on the type of model parameter $MP_j$.

In the aforementioned case 1) and case 2), if a frequency $f_j$ is represented by a corresponding $MP_j$ that comprises only the average value of the normalised amplitudes of $f_j$ and the first time stamp $t_1$, then each reconstructed amplitude $a_{j,i}$ of $f'_j$ for a time stamp $t_i$ in the reconstructed amplitude array will be generated by multiplying the average value of the normalised amplitudes of $f_j$ with the corresponding $SF_i$. That is, the reconstructed amplitudes $a'_{j,i}$ of $f'_j$ will be as follows: [$AV^*SF_1$, $AV^*SF_1$, ----, $AV^*SF_{NoS-1}$, $AV^*SF_{NoS}$].

In the aforementioned case 3), if a frequency $f_j$ is represented by $MP_j$ obtained from an approximation algorithm, for example, a Ramer-Douglas-Peucker algorithm, then each reconstructed amplitude $a'_{j,i}$ of $f_j$ may be generated by passing the $MP_j$ to an inverse approximation algorithm module, in this case an inverse Ramer-Douglas-Peucker algorithm module for obtaining each of reconstructed amplitude $a'_{j,i}$ of $f'_j$ for each of the time stamp $t_i$.

As aforementioned, the CDS is processed for reconstructing a reconstructed normalised amplitude array 180 and subsequently the reconstructed amplitude array 190 of $f_j$. By computing the inverse DFT of each of the columns of the reconstructed amplitude array 190 it is possible to construct $D'_i(nT)$, i.e., the reconstructed partial signals. By contiguous and sequential placement of $D'_i(nT)$ with respect to the time stamps, D'(nT) is constructed.

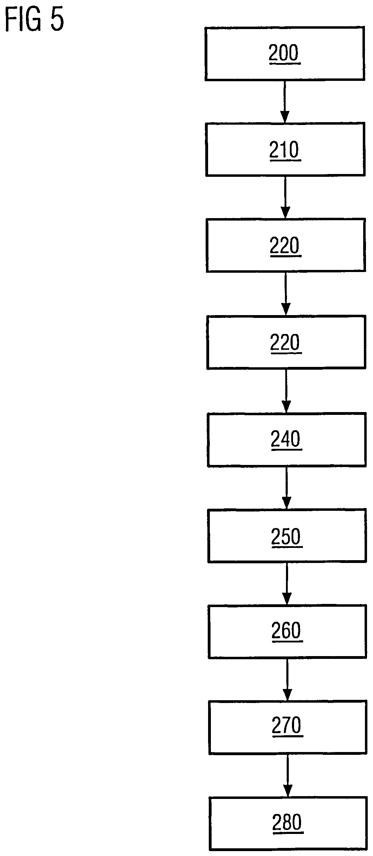

FIG 5 depicts a summarizing flowchart of the method for compressing D(nT) 65 representing A(t) 45. In a step 200, signals $D_i(nT)$ 66-70 with $t_i$ 56-60 are received and the respective $S_i(f)$ 106-110 are computed.

In a subsequent step 210, for each of the NoS number of $S_i(f)$ 106-110, the NoP number of amplitudes $a_{j,i}$ 121-126, each of which correspond to each of $f_j$ 111-116, are received and arranged as aforementioned. Each of $S_i(f)$ 106-110 is time stamped with the respective $t_i$ 56-60. Thus, the amplitude array 128 with NoP rows and NoS columns, wherein each column is assigned to

a time-stamp $t_i$ 56-60, is created. The amplitude array 128 may be created providing outputs of the module 105 to the module 130. Furthermore, for each of $S_i(f)$ 106-110, the corresponding $SF_i$ 135 is computed as aforementioned.

In a following step 220, each column of the amplitude array 128 is normalised to obtain the normalised amplitude array 148 as disclosed in the preceding sections. The amplitude array 128 may be provided to the module 140 for obtaining $b_{j,i}$ 141-146. For each of $S_i(f)$ 106-110, the respective $a_{j,i}$ 121-126 are normalised to obtain $b_{j,i}$ 141-146.

In a subsequent step 230, each of $b_{j,i}$ 141-146 of each of $S_i(f)$ 106-110 is compared with $T_v$, which is proportional to the reciprocal of "NoP", i.e. the cardinal number of frequencies $f_j$ 111-116 of each of $S_i(f)$ 106-110. The normalised amplitude array 148 may be provided to the module 150 for comparing each of $b_{j,i}$ 141-146 of each of $S_i(f)$ 106-110 with $T_v$. Herewith, a distribution of $b_{j,i}$ 141-146 with respect to $T_v$ may be obtained and exemplified.

In a following step 240, for each of $f_j$ 111-116, the distribution of $b_{j,i}$ 141-146 of $f_j$ 111-116 over $S_i(f)$ 106-110 is received for computing the respective $MP_j$ for the respective frequency $f_j$ 111-116 as described above.

In a step 250, the compressed data set (CDS) as defined above is generated.

In a step 260, D'(nT) is reconstructed from CDS. In a following step 270, D'(nT) is correlated with D(nT) 65 for obtaining the correlation co-efficient CC. Based on the determined CC as elucidated in the preceding sections, $T_f$ may be varied in order to vary the threshold value $T_v$. In case CC indicates that the similarity between D'(nT) and D(nT) is not sufficient, a new threshold value $T_v'$ is generated by varying the last threshold value $T_v$. Then, the procedure returns to step 230, wherein each of the normalised amplitudes $b_{j,i}$ 141-146 of each of spectrum $S_i(f)$ 106-110 is compared with the threshold value $T_v=T_v'$. In case CC indicates that the similarity between D'(nT) and D(nT) is sufficient, the procedure continues with step 280.

The correlation co-efficient CC is inversely proportional to the tolerance factor $T_f$.

In step 280, the current compressed data set CDS is stored or, depending on the application, further processed.

Finally, D(nT) 65 is compressed, i.e. storage space for storing the information (amplitude, frequency and time) contained in D(nT) 65 is greatly reduced by merely storing CDS in the memory unit 100. Subsequently, it is possible to use the same either for reference or for transmission also.

In the aforementioned method for compressing D(nT) 65, the step 200 and the steps 260, 270 are optional steps for achieving the object of the invention.

Though the invention has been described with reference to specific embodiments, this description is not meant to be construed in a limiting sense. Various examples of the disclosed embodiments, as well as alternate embodiments of the invention, will become apparent to persons skilled in the art upon reference to the description of the invention. It is therefore contemplated that such modifications can be made without departing from the embodiments of the present invention as defined.

List of reference signs

| 10 | Condition monitoring system |
| 20 | Motor |
| 30 | Data acquisition module |
| 31 | Sensor |
| 32 | Signal conditioner |
| 33 | Analog to Digital converter |
| 40 | Signal processing device |
| 45 | Time dependent signal A(t) |
| 46-50 | Plurality of time dependent partial signals $A_i(t)$ |
| 51-55 | Plurality of time intervals $\Delta t_i$ |
| 56-60 | Plurality of time instances $t_i$ (time stamps) |
| 65 | Date D(nT) |
| 66-70 | Plurality of discrete time partial signals $D_i(nT)$ |
| 90 | Processor |
| 100 | Memory unit |
| 105 | Spectrum module |
| 106-110 | Plurality of spectra $S_i(f)$ |
| 111-116 | Plurality of frequencies $f_j$ |
| 121-126 | Plurality of amplitudes $a_{j,i}$ |
| 128 | Amplitude array |
| 130 | Spectral data receiver module |
| 131-135 | Sum of frequencies $SF_i$ |
| 140 | Amplitude normaliser module |
| 141-146 | Plurality of normalised amplitudes $b_{j,i}$ |
| 148 | Normalised amplitude array |
| 150 | Comparator module |
| 160 | Parameter module |
| 170 | Correlation module |
| 180 | Reconstructed normalised amplitude array |
| 190 | Reconstructed amplitude array |
| 200 | Step of receiving $D_i(nT)$ and computing $S_i(f)$ |
| 210 | Step of creating the amplitude array |
| 220 | Step of creating the normalised amplitude array |
| 230 | Step of comparing the normalised amplitude array with the threshold |
| 240 | Step of processing normalised amplitudes $b_{j,i}$ for computing model parameters $MP_j$ |
| 250 | Step of generating a compressed data set |
| 260 | Step of constructing D'(nT) |
| 270 | Step of correlating D'(nT) and D(nT) |
| 280 | Step of storing the compressed data set |

**Claims**

1. A method for compressing data D(nT) (65) representing a time dependent signal A(t) (45), wherein the time dependent signal A(t) (45) comprises a plurality of time dependent partial signals $A_i(t)$ with i=1,2,..., NoS (46-50, resulting in a plurality discrete-time partial signals $D_i(nT)$ n=1, 2, ..., NoP, the method comprising:

- a step (210) of receiving a plurality of spectra $S_i(f)$ computed from $D_i(nT)$ (106-110), wherein each spectrum $S_i(f)$ (106-110) uniquely corresponds to one of the time dependent partial signals $A_i(t)$ (46-50), wherein each spectrum $S_i(f)$ (106-110) comprises a plurality of frequencies $f_j$ with j=1,2 ,..., NoP (111-116) and a plurality of amplitudes $a_{j,i}$ (121-126) of the plurality of frequencies $f_j$ (111-116),
- for each spectrum $S_i(f)$ (106-110), a step (220) of normalising the plurality of amplitudes $a_{j,i}$ (121-126) for obtaining a plurality of normalised amplitudes $b_{j,i}$ (141-146),
- for each frequency $f_j$ (111-116), a step of processing the normalised amplitudes $b_{j,i}$ (141-146) of the frequency $f_j$ (111-116) based on a distribution of the normalised amplitudes $b_{j,i}$ (141-146) of the frequency $f_j$ (141-146) with respect to a threshold value $T_v$ for determining one or more respective model parameters $MP_j$ for representing the distribution of the normalised amplitudes $b_{j,i}$ (141-146), wherein for each partial signal $A_i(t)$ (46-50), a time stamp $t_i$ (56-60) is generated, wherein the time stamp $t_i$ (56-60) represents a time instant at which the partial signal $A_i(t)$ (46-50) was acquired, wherein, for each frequency $f_j$ (111-116), in case every normalised amplitude $b_{j,i}$ (141-146) of the frequency $f_j$ (111-116) is less than the threshold value $T_v$,
- the respective model parameter $MP_j$ determined by the step of processing comprises an average value AV of the normalised amplitudes $b_{j,i}$ (141-146) of the frequency $f_j$ (111-116),
- a step (250) of generating a compressed data set CDS comprising at least the one or more model parameters $MP_j$ and the frequency $f_j$ (111-116), wherein the compressed data set CDS further comprises:

- the time stamp $t_1$ in case every normalised amplitude $b_{j,k}$ of the frequency $f_j$ is less than the threshold value $T_v$,
- for each spectrum $S_i(f)$ (106-110), a sum $SF_i$ (131-135) of the plurality of amplitudes $a_{j,i}$ (121-126),
- after the step of processing, a step (260) of constructing a reconstructed data D'(nT) by processing the compressed data set CDS,

- a step (270) of determining a correlation coefficient CC by correlating the data D(nT) (65) and the reconstructed data D'(nT), and
- responsive to the correlation coefficient $CC,T_f$ is varied, a step of repeating the step of processing and the step (250) of generating a compressed data set CDS, wherein in the step (250) of processing, the threshold value $T_v$ is proportional to:

      - a reciprocal of a cardinal number NoP of the plurality of frequencies $f_j$ (111-116), and
      - a tolerance factor $T_f$.

2. The method according to claim 1, wherein, for each frequency $f_j$ (111-116), in case a difference $\Delta = b_{j,i}^{max} - b_{j,i}^{min}$ between extreme values $\{b_{j,i}^{max}, b_{j,i}^{min}\}$ of the normalised amplitudes $b_{j,i}$ 141-146 of the frequency $f_j$ (111-116) is less than the threshold value $T_v$,

      - the respective parameter $MP_j$ determined by the step of processing comprises an average value AV of the normalised amplitudes $b_{j,i}$ (141-146) of the frequency $f_j$ (111-116), and
      - the compressed data set CDS further comprises the time stamp $t_1$.

3. The method according to claim 1 or 2, wherein, for each frequency $f_j$ (111-116), in case

      - at least one of the normalised amplitudes $b_{j,i}$ (141-146) of the frequency $f_j$ (111-116) is not less than the threshold value $T_v$ and

      - a difference $\Delta = b_{j,i}^{max} - b_{j,i}^{min}$ between extreme values $\{b_{j,i}^{max}, b_{j,i}^{min}\}$ of the normalised amplitudes $b_{j,i}$ (141-146) of the frequency $f_j$ (111-116) is not less than the threshold value $T_v$, the step of processing performs an approximation algorithm for modelling the distribution of the normalised amplitudes $b_{j,i}$ (141-146), wherein the one or more model parameters $MP_j$ are resulting model parameters of the approximation algorithm.

4. The method according to claim 3, wherein, for those frequencies $f_k$, for which in the step of processing the approximation algorithm for modelling the distribution of the normalised amplitudes has been performed, the compressed data set CDS further comprises the respective time stamps $t_k$.

5. The method according to claim 3 or 4, wherein the approximation algorithm is a polynomial fit.

6. The method according to claim 3 or 4, wherein the approximation algorithm is a step function.

7. The method according to claim 3 or 4, wherein the approximation algorithm is an iterative end point fit algorithm.

8. A signal processing device (40), configured to compress data D(nT) (65) according to any of the methods 1 to 7, the signal processing device (40) comprising:

      - a spectral data receiver module (130) for receiving the plurality of spectra $S_i(f)$ with i=1,2,...,Nos) (106-110),
      - an amplitude normaliser module (140) for normalising the plurality of amplitudes $a_{j,i}$ with j=1,2,...,NoP (121-126) for each of the plurality of frequencies $f_j$ (111-116) of each of the plurality of spectra $S_i(f)$ (106-110) for obtaining the plurality of normalised amplitudes $b_{j,i}$ (141-146),
      - a comparator module (150) for comparing each of the plurality of normalised amplitudes $b_{j,i}$ (141-146) with the threshold value $T_v$,
      - a parameter module (160) for processing the normalised amplitudes $b_{j,i}$ (141-146) of the frequency $f_j$ (111-116) based on the distribution of the normalised amplitudes $b_{j,i}$ (141-146) of each frequency $f_j$ (141-146) with respect to the threshold value $T_v$ for determining the one or more respective parameters $MP_j$ for representing the distribution of the normalised amplitudes $b_{j,i}$ (141-146), and
      - a memory unit (100) for storing the compressed data set (CDS).

9. The signal processing device (40) according to claim 8, further comprising:

      - a correlation module (170) for determining the correlation coefficient CC between the data D(nT) (65) and the reconstructed data D'(nT).

10. The signal processing device (40) according to claim 8 or 9 further comprising:

      - a spectrum module (105) for receiving each of the time dependent partial signals $A_i(t)$ (46-50) for computing the respective spectrum $S_i(f)$ (106-110).

**Patentansprüche**

1. Verfahren zum Komprimieren von Daten D(nT) (65), die ein zeitabhängiges Signal A(t) (45) repräsentieren, wobei das zeitabhängige Signal A(t) (45) eine Vielzahl von zeitabhängigen Teilsignalen $A_i(t)$ (46-50) umfasst, mit i=1, 2, ..., Nos, resultierend in einer Vielzahl von zeitdiskreten Teilsignalen $D_i(nT)$, n=1, 2, ..., NoP, das Verfahren umfassend:

- einen Schritt (210) des Empfangens einer Vielzahl von Spektren $S_i(f)$ (106-110), berechnet aus $D_i(nT)$, wobei jedes Spektrum $S_i(f)$ (106-110) mit einem der zeitabhängigen Teilsignale $A_i(t)$ (46-50) eindeutig korrespondiert, wobei jedes Spektrum $S_i(f)$ (106-110) eine Vielzahl von Frequenzen $f_j$ mit j=1, 2, ..., NoP (111-116) und eine Vielzahl von Amplituden $a_{j,i}$ (121-126) der Vielzahl von Frequenzen $f_j$ (111-116) umfasst,
- für jedes Spektrum $S_i(f)$ (106-110) einen Schritt (220) des Normalisierens der Vielzahl von Amplituden $a_{j,i}$ (121-126) zum Erlangen einer Vielzahl von normalisierten Amplituden $b_{j,i}$ (141-146),
- für jede Frequenz $f_j$ (111-116) einen Schritt des Verarbeitens der normalisierten Amplituden $b_{j,i}$ (141-146) der Frequenz $f_j$ (111-116) basierend auf einer Verteilung der normalisierten Amplituden $b_{j,i}$ (141-146) der Frequenz $f_j$ (141-146) in Bezug auf einen Schwellenwert $T_v$ zum Bestimmen eines oder mehrerer jeweiliger Modellparameter $MP_j$ zum Repräsentieren der Verteilung der normalisierten Amplituden $b_{j,i}$ (141-146), wobei für jedes Teilsignal $A_i(t)$ (46-50) ein Zeitstempel $t_i$ (56-60) erzeugt wird,

wobei der Zeitstempel $t_i$ (56-60) einen Zeitpunkt repräsentiert, zu dem das Teilsignal $A_i(t)$ (46-50) erfasst wurde,
wobei, für jede Frequenz $f_j$ (111-116), im Fall, dass jede normalisierte Amplitude $b_{j,i}$ (141-146) der Frequenz $f_j$ (111-116) kleiner als der Schwellenwert $T_v$ ist,

- der jeweilige Modellparameter $MP_j$, bestimmt durch den Schritt des Verarbeitens, einen Durchschnittswert AV der normalisierten Amplituden $b_{j,i}$ (141-146) der Frequenz $f_j$ (111-116) umfasst,
- einen Schritt (250) des Erzeugens einer komprimierten Datenmenge CDS, umfassend mindestens den einen oder die mehreren Modellparameter $MP_j$ und die Frequenz $f_j$ (111-116), wobei die komprimierte Datenmenge CDS ferner umfasst:

  - den Zeitstempel $t_1$ im Fall, dass jede normalisierte Amplitude $b_{j,k}$ der Frequenz $f_j$ kleiner als der Schwellenwert $T_v$ ist,
  - für jedes Spektrum $S_i(f)$ (106-110) eine

Summe $SF_i$ (131-135) der Vielzahl von Amplituden $a_{j,i}$ (121-126),
- nach dem Schritt des Verarbeitens einen Schritt (260) des Konstruierens rekonstruierter Daten D'(nT) durch Verarbeiten der komprimierten Datenmenge CDS,
- einen Schritt (270) des Bestimmens eines Korrelationskoeffizienten CC durch Korrelieren der Daten D(nT) (65) und der rekonstruierten Daten D'(nT), und
- als Reaktion darauf, dass der Korrelationskoeffizient CC, $T_f$ variiert, einen Schritt des Wiederholens des Schritts des Verarbeitens und des Schritts (250) des Erzeugens einer komprimierten Datenmenge CDS, wobei in dem Schritt (250) des Verarbeitens der Schwellenwert $T_v$ proportional ist zu:

  - einem Kehrwert einer Kardinalzahl NoP der Vielzahl von Frequenzen $f_j$ (111-116) und
  - einem Toleranzfaktor $T_j$.

2. Verfahren nach Anspruch 1, wobei, für jede Frequenz $f_j$ (111-116), im Fall, dass eine Differenz $\Delta = b_{j,i}^{max} - b_{j,i}^{min}$ zwischen Extremwerten $b_{j,i}^{max}$, $b_{j,i}^{min}$ der normalisierten Amplituden $b_{j,i}$ (141-146) der Frequenz $f_j$ (111-116) kleiner als der Schwellenwert $T_v$ ist,

- der jeweilige Parameter $MP_j$, bestimmt durch den Schritt des Verarbeitens, einen Durchschnittswert AV der normalisierten Amplituden $b_{j,i}$ (141-146) der Frequenz $f_j$ (111-116) umfasst, und
- die komprimierte Datenmenge CDS ferner den Zeitstempel $t_1$ umfasst.

3. Verfahren nach Anspruch 1 oder 2, wobei, für jede Frequenz $f_j$ (111-116), im Fall, dass

- mindestens eine der normalisierten Amplituden $b_{j,i}$ (141-146) der Frequenz $f_j$ (111-116) nicht kleiner als der Schwellenwert $T_v$ ist und
- eine Differenz $\Delta = b_{j,i}^{max} - b_{j,i}^{min}$ zwischen Extremwerten $b_{j,i}^{max}$, $b_{j,i}^{min}$ der normalisierten Amplituden $b_{j,i}$ (141-146) der Frequenz $f_j$ (111-116) nicht kleiner als der Schwellenwert $T_v$ ist,

der Schritt des Verarbeitens einen Näherungsalgorithmus zum Modellieren der Verteilung der normalisierten Amplituden $b_{j,i}$ (141-146) durchführt, wobei der eine oder die mehreren Modellparameter $MP_j$ resultierende Modellparameter des Näherungsalgorithmus sind.

4.  Verfahren nach Anspruch 3, wobei, für diejenigen Frequenzen $f_k$, für die in dem Schritt des Verarbeitens der Näherungsalgorithmus zum Modellieren der Verteilung der normalisierten Amplituden durchgeführt wurde, die komprimierte Datenmenge CDS ferner die jeweiligen Zeitstempel $t_k$ umfasst.

5.  Verfahren nach Anspruch 3 oder 4, wobei der Näherungsalgorithmus eine polynomische Anpassung ist.

6.  Verfahren nach Anspruch 3 oder 4, wobei der Näherungsalgorithmus eine Stufenfunktion ist.

7.  Verfahren nach Anspruch 3 oder 4, wobei der Näherungsalgorithmus ein iterativer Endpunktanpassung-Algorithmus ist.

8.  Signalverarbeitungsvorrichtung (30), konfiguriert zum Komprimieren von Daten D(nT) (65) nach einem der Ansprüche 1 bis 7, die Signalverarbeitungsvorrichtung (40) umfassend:

    - ein Spektraldatenempfängermodul zum Empfangen der Vielzahl von Spektren $S_i(f)$ (106-110) mit i=1, 2, ..., NoS,
    - ein Amplitudennormalisierungsmodul (140) zum Normalisieren der Vielzahl von Amplituden $a_{j,i}$ (121-126) mit j=1, 2, ..., NoP für jede der Vielzahl von Frequenzen $f_j$ (111-116) von jedem der Vielzahl von Spektren $S_i(f)$ (106-110) zum Erlangen einer Vielzahl von normalisierten Amplituden $b_{j,i}$ (141-146),
    - ein Vergleichsmodul (150) zum Vergleichen jeder der Vielzahl von normalisierten Amplituden $b_{j,i}$ (141-146) mit dem Schwellenwert $T_v$,
    - ein Parametermodul (160) zum Verarbeiten der normalisierten Amplituden $b_{j,i}$ (141-146) der Frequenz $f_j$ (111-116) basierend auf der Verteilung der normalisierten Amplituden $b_{j,i}$ (141-146) der Frequenz $f_j$ (141-146) in Bezug auf einen Schwellenwert $T_v$ zum Bestimmen des eines oder der mehreren jeweiligen Parameter $MP_j$ zum Repräsentieren der Verteilung der normalisierten Amplituden $b_{j,i}$ (141-146), und
    - eine Speichereinheit (100) zum Speichern der komprimierten Datenmenge (CDS).

9.  Signalverarbeitungsvorrichtung (40) nach Anspruch 8, ferner umfassend:

    - ein Korrelationsmodul (170) zum Bestimmen des Korrelationskoeffizienten CC zwischen den Daten D(nT) (65) und den rekonstruierten Daten D'(nT).

10. Signalverarbeitungsvorrichtung (40) nach Anspruch 8 oder 9, ferner umfassend:

    - ein Spektrumsmodul (105) zum Empfangen jedes der zeitabhängigen Teilsignale $A_i(t)$ (46-50) zum Berechnen des jeweiligen Spektrums $S_i(f)$ (106-110).

## Revendications

1.  Procédé de compression de données D(nT)(65) représentant un signal A(t)(45) dépendant du temps, dans lequel le signal A(t)(45) dépendant du temps comprend une pluralité de signaux $A_1(t)$ partiels dépendant du temps avec i=1, 2, ...n, NoS (46 à 50) se traduisant par une pluralité de signaux $D_i(nT)$ n=1, 2, ..., NoP partiels discrets dans le temps, le procédé comprenant :

    - un stade (210) de réception d'une pluralité de spectres $S_i(f)$ calculés à partir de $D_i(nT)$ '106 à 110), chaque spectre $S_i(f)$ (106 à 110) correspondant uniquement à l'un des signaux $A_i(t)$ (46 à 50) partiels dépendants du temps, chaque spectre $S_i(f)$ (106 à 110) comprenant une pluralité de fréquences $f_j$ avec j=1, 2, ..., NoP (111 à 116) et une pluralité d'amplitudes $a_{j,i}$ (121 à 126) de la pluralité de fréquences $f_j$ (111 à 116),
    - pour chaque spectre $S_i(f)$ (106 à 110), un stade (220) dans lequel on norme la pluralité d'amplitudes $a_{j,i}$ (121 à 126) pour obtenir une pluralité d'amplitudes $b_{j,i}$ (141 à 146) normées,
    - pour chaque fréquence $f_j$ (111 à 116), un stade de traitement des amplitudes $b_{j,i}$ (141 à 146) normées de la fréquence $f_j$ (111 à 116) sur la base d'une distribution des amplitudes $b_{j,i}$ (141 à 146) normées de la fréquence $f_j$ (141 à 146) par rapport à une valeur $T_v$ de seuil pour déterminer un ou plusieurs paramètres $MP_J$ respectif de modèle afin de représenter la distribution des amplitudes $b_{j,i}$ (141 à 146) normées,

    dans lequel il est créé, pour chaque signal $A_i(t)$ (46 à 50) partiel un horodatage $t_i$ (56 à 60),
    dans lequel l'horodatage $t_i$ (56 à 60) représente un instant où le signal $A_i(t)$ (46 à 50) a été acquis,
    dans lequel, pour chaque fréquence $f_j$ (111 à 116), dans le cas où chaque amplitude $b_{j,i}$ (141 à 146) normée de la fréquence $f_j$ (111 à 116) est plus petite que la valeur $T_v$ de seuil,

    - le paramètre $MP_j$ respectif de modèle, déterminé par le stade de traitement, comprend une valeur AV moyenne des amplitudes $b_{j,i}$ (141 à 146) normées de la fréquence $f_j$ (111 à 116),

- un stade (250) de création d'un jeu CDS de données compressées comprenant au moins le un ou les plusieurs paramètres $MP_j$ de modèle et la fréquence $f_j$ (111 à 116), dans lequel le jeu CDS de données compressées comprend en outre :

     - l'horodatage $t_1$, dans le cas où chaque amplitude $b_{j,k}$ normée de la fréquence $f_j$ est plus petite que la valeur $T_{v'}$ de seuil,
     - pour chaque spectre $S_i(f)$ (106 à 110), une somme $SF_i$ (131 à 135) de la pluralité d'amplitudes $a_{j,i}$ (121 à 126),
     - après le stade de traitement, un stade (260) de construction d'une donnée $D'(nT)$ reconstruite, en traitant le jeu CDS de données comprimées,
     - un stade (270) de détermination d'un coefficient CC de corrélation, en corrélant la donnée $D(nT)$ (65) et la donnée $D'(nT)$ reconstruite et
     - en réponse à la corrélation, le coefficient $CC, T_f$ est modifié,

un stade de répétition du stade de traitement et du stade (250) de création d'un jeu CDS de données compressées, dans lequel, dans le stade (250) de traitement, la valeur $T_v$ de seuil est proportionnelle à :

     - un inverse d'un nombre NoP cardinal de la pluralité de fréquences $f_j$ (111 à 116) et
     - un facteur Tf de tolérance.

2. Procédé suivant la revendication 1, dans lequel, pour chaque fréquence $f_j$ (111 à 116), dans le cas où une différence $\Delta = b_{j,i}^{max} - b_{j,i}^{min}$ entre des valeurs $b_{j,i}^{max}$, $b_{j,i}^{min}$ extrêmes des amplitudes $b_{j,i}$ (141 à 146) normées de la fréquence $f_j$ (111 à 116) est plus petite que la valeur $T_v$ de seuil,

     - le paramètre $MP_j$ respectif déterminé par le stade de traitement comprend une moyenne AV des amplitudes $b_{j,i}$ (141 à 146) normées de la fréquence $f_j$ (111 à 116) et
     - le jeu CDS de données compressées comprend en outre l'horodatage $t_1$.

3. Procédé suivant la revendication 1 ou 2, dans lequel, pour chaque fréquence $f_j$ (111 à 116), dans le cas où

     - au moins l'une des amplitudes $b_{j,i}$ (141 à 146) normées de la fréquence $f_j$ (111 à 116) n'est pas plus petite que la valeur $T_v$ de seuil et
     - une différence $\Delta = b_{j,i}^{max} - b_{j,i}^{min}$ entre des valeurs $b_{j,i}^{max}$, $b_{j,i}^{min}$ extrêmes des amplitudes $b_{j,i}$ (141 à 146) normées de la fréquence $f_j$ (111 à 116) n'est pas plus petite que la valeur $T_v$ de

seuil,
     - le stade de traitement effectue un algorithme d'approximation pour modéliser la distribution des amplitudes $b_{j,i}$ (141 à 146) normées, dans lequel l'un ou les plusieurs paramètres $MP_j$ de modèle sont des paramètres de modèle résultant de l'algorithme d'approximation.

4. Procédé suivant la revendication 3, dans lequel, pour les fréquences $f_k$, pour lesquelles, dans le stade de traitement, l'algorithme d'approximation de modélisation de la distribution des amplitudes normées a été effectué, le jeu CDS de données comprimées comprend en outre des horodatages $t_k$ respectifs.

5. Procédé suivant la revendication 3 ou 4, dans lequel l'algorithme d'approximation est un ajustement polynomial.

6. Procédé suivant la revendication 3 ou 4, dans lequel l'algorithme d'approximation est une fonction à échelon.

7. Procédé suivant la revendication 3 ou 4, dans lequel l'algorithme d'approximation est un algorithme d'ajustement itératif à pont de fin.

8. Dispositif (40) de traitement d'un signal configuré pour comprimer des données $D(nT)$ (65) suivant l'un quelconque des procédés 1 à 7, le dispositif (40) de traitement d'un signal comprenant :

     - un module (130) récepteur de données spectrales pour recevoir la pluralité de spectres Si(f) avec (i=1, 2, ..., NoS) (106 à 110),
     - un module (140) normateur d'amplitude pour normer la pluralité d'amplitudes $a_{j,i}$ avec (j=1, 2, ..., NoP) (121 à 126) pour chacune de la pluralité de fréquences $f_j$ (111 à 116) de chacun de la pluralité de spectres Si(f) (106 à 110) pour obtenir la pluralité d'amplitudes $b_{j,i}$ (141 à 146) normées,
     - un module (150) comparateur pour comparer chacune de la pluralité d'amplitudes $b_{j,i}$ (141 à 146) normées à la valeur $T_v$ de seuil,
     - un module (160) de paramètre pour traiter des amplitudes $b_{j,i}$ (141 à 146) normées de la fréquence $f_j$ (111 à 116) sur la base de la distribution des amplitudes $b_{j,i}$ (141 à 146) normées de chaque fréquence $f_j$ (141 à 146) par rapport à la valeur $T_v$ de seuil,
pour déterminer le un ou les plusieurs paramètres MP respectifs pour représenter la distribution des amplitudes $b_{j,i}$ (141 à 146) normées et
     - une unité (100 de mémoire pour mémoriser le jeu (CDS) de données compressées.

9. Dispositif (40) de traitement d'un signal suivant la revendication 8, comprenant en outre :

- un module (170) de corrélation pour déterminer le coefficient CC de corrélation entre les données D(nT) (65) et les données D'(nT) reconstruites.

**10.** Dispositif (40) de traitement d'un signal suivant la revendication 8 ou 9, comprenant en outre :

- un module (105) de spectre pour recevoir chacun des signaux $A_i(t)$ (46 à 50) partiel dépendant du temps pour calculer le spectre $S_i(f)$ (106 à 110) respectif.

## FIG 1A

EP 2 803 141 B1

FIG 1B

EP 2 803 141 B1

FIG 2A

EP 2 803 141 B1

## FIG 2B

# FIG 2C

130

56-60

|  | $t_1$ | $t_2$ | $t_3$ | $t_4$ | $t_5$ |
|---|---|---|---|---|---|
| $f_1$ | $a_{1,1}$ | $a_{1,2}$ | $a_{1,3}$ | $a_{1,4}$ | $a_{1,5}$ |
| $f_2$ | $a_{2,1}$ | $a_{2,2}$ | $a_{2,3}$ | $a_{2,4}$ | $a_{2,5}$ |
| $f_3$ | $a_{3,1}$ | $a_{3,2}$ | $a_{3,3}$ | $a_{3,4}$ | $a_{3,5}$ |
| $f_4$ | $a_{4,1}$ | $a_{4,2}$ | $a_{4,3}$ | $a_{4,4}$ | $a_{4,5}$ |
| $f_5$ | $a_{5,1}$ | $a_{5,2}$ | $a_{5,3}$ | $a_{5,4}$ | $a_{5,5}$ |
| $f_6$ | $a_{6,1}$ | $a_{6,2}$ | $a_{6,3}$ | $a_{6,4}$ | $a_{6,5}$ |
| SF | $SF_1$ | $SF_2$ | $SF_3$ | $SF_4$ | $SF_5$ |

111-116

121-126

131-135

128

140

56-60

|  | $t_1$ | $t_2$ | $t_3$ | $t_4$ | $t_5$ |
|---|---|---|---|---|---|
| $f_1$ | $b_{1,1}$ | $b_{1,2}$ | $b_{1,3}$ | $b_{1,4}$ | $b_{1,5}$ |
| $f_2$ | $b_{2,1}$ | $b_{2,2}$ | $b_{2,3}$ | $b_{2,4}$ | $b_{2,5}$ |
| $f_3$ | $b_{3,1}$ | $b_{3,2}$ | $b_{3,3}$ | $b_{3,4}$ | $b_{3,5}$ |
| $f_4$ | $b_{4,1}$ | $b_{4,2}$ | $b_{4,3}$ | $b_{4,4}$ | $b_{4,5}$ |
| $f_5$ | $b_{5,1}$ | $b_{5,2}$ | $b_{5,3}$ | $b_{5,4}$ | $b_{5,5}$ |
| $f_6$ | $b_{6,1}$ | $b_{6,2}$ | $b_{6,3}$ | $b_{6,4}$ | $b_{6,5}$ |

111-116

141-146

148

# FIG 3

56-60

| | $t_1$ | $t_2$ | $t_3$ | $t_4$ | $t_5$ |
|---|---|---|---|---|---|
| $f_1$ | 5 | 7 | 23 | 4 | 21 |
| $f_2$ | 21 | 20 | 20 | 21 | 22 |
| $f_3$ | 8 | 4 | 4 | 9 | 11 |
| $f_4$ | 21 | 20 | 5 | 7 | 4 |
| $f_5$ | 23 | 24 | 26 | 24 | 23 |
| $f_6$ | 20 | 3 | 19 | 2 | 26 |
| SF | 98 | 78 | 97 | 67 | 107 |

111-116

121-126

131-135

128

56-60

| | $t_1$ | $t_2$ | $t_3$ | $t_4$ | $t_5$ |
|---|---|---|---|---|---|
| $f_1$ | 0.05 | 0.09 | 0.24 | 0.06 | 0.20 |
| $f_2$ | 0.21 | 0.26 | 0.21 | 0.31 | 0.21 |
| $f_3$ | 0.08 | 0.05 | 0.04 | 0.13 | 0.10 |
| $f_4$ | 0.21 | 0.26 | 0.05 | 0.10 | 0.04 |
| $f_5$ | 0.23 | 0.31 | 0.27 | 0.36 | 0.21 |
| $f_6$ | 0.20 | 0.04 | 0.20 | 0.03 | 0.24 |

111-116

141-146

148

# FIG 4A

128

| | $t_1$ | $t_2$ | $t_3$ | $t_4$ | $t_5$ | $t_6$ | $t_7$ | $t_8$ | $t_9$ | $t_{10}$ |
|---|---|---|---|---|---|---|---|---|---|---|
| $f_1$ | 5.00 | 6.00 | 6.00 | 7.00 | 5.00 | 6.00 | 1.00 | 2.00 | 5.00 | 3.00 |
| $f_2$ | 54.00 | 56.00 | 52.00 | 54.00 | 52.00 | 58.00 | 59.00 | 55.00 | 53.00 | 51.00 |
| $f_3$ | 10.00 | 20.00 | 30.00 | 10.00 | 20.00 | 30.00 | 0.00 | 20.00 | 30.00 | 30.00 |
| $f_4$ | 20.00 | 5.00 | 25.00 | 30.00 | 23.00 | 5.00 | 24.00 | 6.00 | 23.00 | 5.00 |
| SF | 89.00 | 87.00 | 113.00 | 101.00 | 100.00 | 99.00 | 84.00 | 83.00 | 111.00 | 89.00 |

148

| | $t_1$ | $t_2$ | $t_3$ | $t_4$ | $t_5$ | $t_6$ | $t_7$ | $t_8$ | $t_9$ | $t_{10}$ |
|---|---|---|---|---|---|---|---|---|---|---|
| $f_1$ | 0.06 | 0.07 | 0.05 | 0.07 | 0.05 | 0.06 | 0.01 | 0.02 | 0.05 | 0.03 |
| $f_2$ | 0.61 | 0.64 | 0.46 | 0.53 | 0.52 | 0.59 | 0.70 | 0.66 | 0.48 | 0.57 |
| $f_3$ | 0.11 | 0.23 | 0.27 | 0.10 | 0.20 | 0.30 | 0.00 | 0.24 | 0.27 | 0.34 |
| $f_4$ | 0.22 | 0.06 | 0.22 | 0.30 | 0.23 | 0.05 | 0.29 | 0.07 | 0.21 | 0.06 |

# FIG 4B

180

| | $t_1$ | $t_2$ | $t_3$ | $t_4$ | $t_5$ | $t_6$ | $t_7$ | $t_8$ | $t_9$ | $t_{10}$ |
|---|---|---|---|---|---|---|---|---|---|---|
| $f_1$ | 0.05 | 0.05 | 0.05 | 0.05 | 0.05 | 0.05 | 0.05 | 0.05 | 0.05 | 0.05 |
| $f_2$ | 0.58 | 0.58 | 0.58 | 0.58 | 0.58 | 0.58 | 0.58 | 0.58 | 0.58 | 0.58 |
| $f_3$ | 0.11 | 0.11 | 0.11 | 0.11 | 0.11 | 0.30 | 0.00 | 0.24 | 0.24 | 0.34 |
| $f_4$ | 0.22 | 0.06 | 0.06 | 0.30 | 0.30 | 0.05 | 0.29 | 0.07 | 0.21 | 0.06 |

190

| | $t_1$ | $t_2$ | $t_3$ | $t_4$ | $t_5$ | $t_6$ | $t_7$ | $t_8$ | $t_9$ | $t_{10}$ |
|---|---|---|---|---|---|---|---|---|---|---|
| $f_1$ | 4.18 | 4.09 | 5.31 | 4.75 | 4.70 | 4.65 | 3.95 | 3.90 | 5.22 | 4.18 |
| $f_2$ | 51.26 | 50.11 | 65.09 | 58.18 | 57.60 | 57.02 | 48.38 | 47.81 | 63.94 | 51.26 |
| $f_3$ | 9.79 | 9.57 | 12.43 | 11.11 | 11.00 | 29.70 | 0.00 | 19.92 | 26.64 | 30.26 |
| $f_4$ | 19.58 | 5.22 | 6.78 | 30.30 | 30.00 | 4.95 | 24.36 | 5.81 | 23.31 | 5.34 |

FIG 5